# FASCICULE DE BREVET EUROPEEN

(11) **EP 2 526 071 B1**
(45) Date de publication et mention de la délivrance du brevet: **04.11.2020**
(21) Numéro de dépôt: 11704279.6
(22) Date de dépôt: 12.01.2011
(51) Int. Cl.: C03C 8/04, C03C 17/36, C03C 4/20, C03C 17/34, H01L 51/52

(54) **SUBSTRAT VERRIER REVETU D'UNE COUCHE HAUT INDICE SOUS UN REVETEMENT ELECTRODE ET DISPOSITIF ELECTROLUMINESCENT ORGANIQUE COMPORTANT UN TEL SUBSTRAT**
MIT EINER SCHICHT MIT HOHEM BRECHUNGSINDEX UNTER EINER ELEKTRODENBESCHICHTUNG BESCHICHTETES GLASSUBSTRAT UND ORGANISCHES LICHTEMITTIERENDES BAUELEMENT MIT EINEM DERARTIGEN SUBSTRAT
GLASS SUBSTRATE COATED WITH A HIGH-INDEX LAYER UNDER AN ELECTRODE COATING, AND ORGANIC LIGHT-EMITTING DEVICE COMPRISING SUCH A SUBSTRATE

(30) Priorité: 22.01.2010 FR 1050420
(43) Date de publication de la demande: 28.11.2012
(73) Titulaire: SAINT-GOBAIN GLASS FRANCE, 92400 Courbevoie (FR)
(72) Inventeur: VERMERSCH, François-Julien, F-75014 Paris (FR); ABENSOUR, Sylvie, F-95680 Montlignon (FR); ALLANO, Jean-Luc, F-95170 Deuil la Barre (FR); EHRENSPERGER, Marie-Virginie, F-75013 Paris (FR)
(74) Mandataire: Saint-Gobain Recherche
(86) Numéro de dépôt international: PCT/FR2011/050052
(87) Numéro de publication internationale: WO 2011/089343

(56) Documents cités:
- EP-A2- 1 100 129
- WO-A1-2010/084922
- US-A- 5 252 521
- US-A1- 2009 153 972

## Description

La présente invention concerne un substrat verrier pourvu sur l'une de ses faces d'une électrode.

Elle concerne plus particulièrement un substrat verrier pour une structure servant de support à un dispositif à diode électroluminescente organique, dit « OLED » pour « Organic Light Emitting Diodes » en anglais.

L'OLED comporte un matériau, ou un empilement de matériaux, électroluminescent(s) organique(s), et est encadrée par deux électrodes, l'une des électrodes, dite inférieure, généralement l'anode, étant constituée par celle associée au substrat verrier et l'autre électrode, dite supérieure, généralement la cathode, étant agencée sur le système électroluminescent organique.

L'OLED est un dispositif qui émet de la lumière par électroluminescence en utilisant l'énergie de recombinaison de trous injectés depuis l'anode et d'électrons injectés depuis la cathode.

Il existe différentes configurations d'OLED :
- les dispositifs à émission par l'arrière (« bottom émission » en anglais), c'est-à-dire ave une électrode inférieure (semi) transparente et une électrode supérieure réfléchissante ;
- les dispositifs à émission par l'avant (« top émission » en anglais), c'est-à-dire avec une électrode supérieure (semi) transparente et une électrode inférieure réfléchissante ;
- les dispositifs à émission par l'avant et l'arrière, c'est-à-dire avec à la fois une électrode inférieure (semi) transparente et une électrode supérieure (semi) transparente.

L'invention a trait aux dispositifs OLED à émission par l'arrière et éventuellement aussi par l'avant.

Une OLED trouve généralement son application dans un écran de visualisation ou un dispositif d'éclairage avec des contraintes différentes.

Pour un système d'éclairage général, la lumière extraite de l'OLED est une lumière « blanche » en émettant dans certaines voire toutes longueurs d'onde du spectre. Elle doit l'être en outre de manière homogène. On parle à ce sujet plus précisément d'une émission lambertienne, c'est-à-dire obéissant à la loi de Lambert en étant caractérisée par une luminance photométrique égale dans toutes les directions.

Par ailleurs, une OLED présente une faible efficacité d'extraction de lumière : le rapport entre la lumière qui sort effectivement du substrat verrier et celle émise par les matériaux électroluminescents est relativement faible, de l'ordre de 0,25.

Ce phénomène, s'explique d'une part, par le fait qu'une certaine quantité de photons reste emprisonnée dans des modes guidés entre les électrodes et d'autre part, par la réflexion de la lumière au sein du substrat verrier du fait de la différence d'indice entre le verre du substrat (n de l'ordre de 1,5) et l'air extérieur au dispositif (n = 1).

II est donc recherché des solutions pour améliorer l'efficacité d'une OLED, à savoir augmenter le gain en extraction tout en fournissant une lumière qui soit blanche, c'est-à-dire émettant dans certaines, voire toutes, longueurs d'onde du spectre visible.

Les solutions habituellement proposées concernent le substrat verrier, soit au niveau de l'interface verre-air, on parlera de solutions d'optique géométrique car faisant le plus souvent appel à l'optique géométrique, soit au niveau de l'interface verre-électrode inférieure, on parlera de solutions d'optique diffractive car ayant recours habituellement à l'optique diffractive.

II est connu en tant que solution d'optique diffractive d'apporter à l'interface verre-électrode inférieure une structure à saillies périodiques qui constitue un réseau de diffraction. La demande de brevet américain N° US 2004/0227462 montre une solution d'optique diffractive. A cet effet ce document divulgue une OLED dont le substrat transparent, support de l'électrode inférieure et de la couche organique, est texturé. La surface du substrat présente ainsi une alternance d'excroissances et de creux dont le profil est suivi par l'électrode inférieure et la couche organique déposées dessus.

Cependant si une telle solution est efficace pour extraire la lumière monochromatique, c'est-à-dire dans une direction donnée de l'espace, elle n'est pas aussi performante pour la lumière polychromatique telle que la lumière blanche pour un application d'éclairage.

En outre, dans ce document US 2004/0227462, le profil du substrat est obtenu en appliquant un masque en résine photosensible sur la surface du substrat dont le motif correspond à celui recherché pour les excroissances, puis en gravant la surface au travers du masque. Un tel procédé n'est pas facile à mettre en œuvre de façon industrielle sur de grandes surfaces de substrat, et est surtout trop onéreux, tout particulièrement pour des applications d'éclairage.

La demande internationale de brevet N° WO 05/081334 propose une autre solution d'optique diffractive qui consiste à recouvrir un substrat verrier plan d'une couche polymère texturée obtenue par embossage, l'électrode inférieure et la couche organique étant ensuite déposées en suivant le profil de la couche polymère. Les ondulations de la couche, qui peuvent être périodiques ou non, présentent des grandeurs telles que la distance séparant un sommet d'un fond d'ondulation est comprise entre 0,5 µm et 200 µm.

Cependant, avec une telle solution, on a toutefois observé de nombreuses défaillances électriques des OLEDS.

Les meilleures performances actuelles ont été obtenues avec des OLEDs déposées sur des substrats haut-indice. En effet, en jouant sur l'indice du substrat verrier, la répartition des modes peut-être complètement modifiée.

En effet, dans le cas d'un substrat verrier d'indice 1,5, seul 50% des photons environ atteindront le substrat, le reste étant piégé dans les couches organiques et l'électrode inférieure.

En prenant un substrat avec un indice en accord avec celui de l'anode et de(s) couche(s) organique(s) (soit environ 1,8), des modes auparavant piégés dans l'anode et/ou la (ou les) couche(s) organique(s) peuvent être extraits et environ 80% des photons peuvent être ainsi rendus disponibles.

Toutefois, les substrats haut-indice qui seraient disponibles actuellement sont très coûteux et contiennent du plomb, qui est un élément nocif.

Une autre solution est exposée dans la demande de brevet américain N° US 2009/0153972 : dans ce document, il est proposé de disposer une couche de matériau vitreux sur une face d'un substrat verrier, entre cette face et un revêtement électrode, cette couche de matériau vitreux comportant des éléments diffusants, la distribution de ces éléments diffusants à l'intérieur de la couche de matériau vitreux allant en diminuant en direction du revêtement électrode.

La demande EP 2 383 235 A1 qui fait partie de l'état de la technique conformément à l'article 54(3) CBE, divulgue un verre destiné à être utilisé comme couche de diffusion d'un dispositif LED organique, ou un dispositif LED organique comprenant la couche de diffusion. Le dispositif LED organique comprend un substrat transparent, une première électrode disposée sur le substrat transparent, une couche organique disposée sur la première électrode, et une seconde électrode disposée sur la couche organique, et est caractérisé en ce qu'il comporte une couche de diffusion qui comprend, en termes de quantité d'oxyde en % molaire, 15-30% de P₂O₅, 5-25% de Bi₂O₃, 5-27% de Nb₂O₅, et 4-35% de ZnO et qui contient des oxydes de métaux alcalins constitués de Li₂O, Na₂O, et K₂O en une quantité totale de 5% en masse ou moins.

Ainsi, la couche de matériau vitreux présente un indice qui augmente en direction du revêtement électrode.

Toutefois, la couche de matériau vitreux ne présente pas une résistance chimique suffisante vis-à-vis des attaques chimiques acides et basiques habituelles opérées sur le substrat revêtu du revêtement électrode.

L'invention a donc pour but de fournir un substrat en verre minéral pourvu sur l'une de ses faces d'une électrode transparente, le substrat étant destiné à constituer le support d'un dispositif OLED convenant pour l'éclairage, qui soit de conception simple, fiable et permette d'améliorer par rapport aux solutions existantes, l'extraction de lumière émise par ledit dispositif tout en étant peu onéreux à fabriquer.

Un autre but important est de permettre de fabriquer un tel substrat sans contrainte environnementale sévère.

Un autre but important est de permettre de fabriquer un tel substrat qui soit compatible avec les procédés de dépôt des couches du système électroluminescent organique.

La présente invention repose sur l'utilisation d'au moins une couche particulière en un matériau vitreux présentant un indice haut (c'est-à-dire un indice supérieur à celui du substrat et qui peut être inférieur, identique ou supérieur à celui de l'OLED) et qui est disposée entre la seconde face du substrat et le revêtement électrode adjacent. Cette couche, bien que relativement épaisse, est toutefois bien moins épaisse (au moins 10 à 100 fois moins) que le substrat lui-même et est donc moins cher à fabriquer qu'un substrat spécifique à haut indice, tout en présentant une résistance chimique améliorée, permettant le dépôt à échelle industrielle, sur le revêtement électrode, d'un système électroluminescent organique.

La présente invention telle que définie dans la revendication 1 consiste ainsi dans son acception la plus large en un substrat en verre comportant une première face et une seconde face qui est opposée à la première, ledit substrat comportant au-dessus de sa seconde face un revêtement électrode qui comporte au moins une couche électriquement conductrice avec au moins une couche de matériau vitreux (3) comporte des éléments diffusants qui sont des particules de matière d'indice différent de celui de la couche de matériau vitreux et/ou ledit substrat (10) comporte des éléments diffusants et/ou en ce que ladite première face (11) du substrat (10) est diffusante et/ou est revêtue d'un revêtement diffusant, caractérisé en ce que ledit substrat comporte entre sa seconde face et le revêtement électrode au moins une couche de matériau vitreux présentant un indice compris entre 1,7 et 2,4 en incluant ces valeurs et comprenant d'une part entre 40 % et 60 % en poids en incluant ces valeurs, voire entre 45 % et 58 % en poids en incluant ces valeurs, d'oxyde de bismuth Bi₂O₃ et d'autre part entre 5 % et 30 % en poids, en incluant ces valeurs et de préférence entre 10 et 25 % en poids, en incluant ces valeurs, de ZnO.

Le substrat présente ainsi un indice bas, compris entre 1,4 et 1,6 et le matériau vitreux de la couche de matériau vitreux présente un indice haut, plus élevé que l'indice bas du substrat. Cet indice haut est inférieur, égal ou supérieur à l'indice généralement haut de la source d'émission de lumière et notamment d'un système électroluminescent organique.

Dans toute la description, le substrat selon l'invention est considéré posé horizontalement, avec sa première face orientée vers le bas et sa seconde face, opposée à la première face, orientée vers le haut ; les sens des expressions « au-dessus » et « en-dessous » est ainsi à considérer par rapport à cette orientation. A défaut de stipulation spécifique, les expressions « au-dessus » et « en-dessous » ne signifie pas nécessairement que les deux éléments sont disposés au contact l'un de l'autre.

Les termes « inférieur » et « supérieur » sont utilisés ici en référence à ce positionnement.

Dans toute la description, le terme « indice » fait référence à l'indice optique de réfraction, mesuré à la longueur d'onde de 590 nm.

La couche de matériau vitreux peut être ce que l'homme du métier nomme un émail ou une fritte.

Ladite couche de matériau vitreux présente, de préférence, une épaisseur comprise, entre 1 µm et 100 µm, voire entre 2 µm et 80 µm, voire entre 5 µm et 60 µm.

Le substrat selon l'invention peut comporter entre sa seconde face et le revêtement électrode plusieurs couches de matériau vitreux présentant chacune un indice différent, une couche de matériau vitreux disposée en direction de ladite seconde face du substrat présentant un indice inférieur à celui d'une autre couche de matériau vitreux disposée en direction dudit revêtement électrode et lesdites couches de matériau vitreux comprenant, de préférence toutes, d'une part entre 40 % et 60 % en poids en incluant ces valeurs , voire entre 45 % et 58 % en poids en incluant ces valeurs, d'oxyde de bismuth Bi₂O₃ et d'autre part entre 5 % et 30 % en poids, en incluant ces valeurs et de préférence entre 10 et 25 % en poids, en incluant ces valeurs, de ZnO.

Il est ainsi possible de réaliser un gradient d'indice avec une diminution progressive de l'indice en deux étapes (deux couches), ou plus, entre le revêtement électrode et le substrat bas indice et chaque couche de matériau vitreux présentant de préférence un indice compris entre 1,7 et 2,4.

Toutefois, il est possible qu'au moins deux couches de matériau vitreux ne présentent pas la même proportion d'oxyde de bismuth Bi₂O₃ et/ou pas la même proportion d'oxyde de zinc ZnO, tout en restant dans la plage large ci-dessus. Il est ainsi possible d'une part qu'une couche de matériau vitreux comprenne entre 40 % et 60 % en poids en incluant ces valeurs d'oxyde de bismuth Bi₂O₃, et qu'une autre couche de matériau vitreux comprenne entre 45 % et 58 % en poids en incluant ces valeurs d'oxyde de bismuth Bi₂O₃, et/ou d'autre part qu'une couche de matériau vitreux comprenne entre 5 % et 30 % en poids, en incluant ces valeurs, de ZnO et qu'une autre couche de matériau vitreux comprenne entre 10 et 25 % en poids, en incluant ces valeurs, de ZnO.

Selon une variante de réalisation de l'invention, au moins une couche de matériau vitreux, et de préférence chaque couche de matériau vitreux s'il y en a plusieurs, comporte des éléments diffusants, en particulier des bulles d'air et/ou des particules de matière d'indice différent de celui de la couche de matériau vitreux, comme par exemple des particules à base d'oxyde de titane qui vont présenter un indice de l'ordre de 2,4 à 2,7, et/ou des cristaux, comme par exemple des cristaux de zircon ou de baddeleyite.

Ainsi, selon cette variante, ladite couche de matériau vitreux ou au moins une desdites couches de matériau vitreux, voire toutes les couches de matériau vitreux est (ou sont) intrinsèquement diffusante(s).

Selon une autre variante de réalisation, au moins une couche de matériau vitreux, et de préférence chaque couche de matériau vitreux s'il y en a plusieurs, comporte en poids :
- entre 0 % et 10 % et de préférence entre 0 et 5 % de SiO₂,
- entre 0 % et 5 % et de préférence entre 0 et 1 % d'Al₂O₃,
- entre 8 % et 25 % et de préférence entre 10 et 22 % de B₂O₃,
- entre 0 % et 10 % et de préférence entre 0 et 5 % de CaO,
- entre 0 % et 20 % et de préférence entre 0 et 15 % de BaO,
- entre 0 % et 5 % et de préférence entre 0 et 3 % de Li₂O,
- entre 0 % et 10 % et de préférence entre 0 et 5 % de Na₂O,
- entre 0 % et 5 % et de préférence entre 0 et 3 % de K₂O,
- entre 0 % et 5 % et de préférence entre 0 et 4 % de ZrO₂,
- entre 0 % et 5 % de SrO,
- entre 0 % et 5 % deLa₂O₃,
en incluant ces valeurs dans les plages.

Selon une autre variante de réalisation, ledit substrat comporte des éléments diffusants, en particulier des particules de matière d'indice différent de celui de la couche de matériau vitreux, comme par exemple des particules à base d'oxyde de titane qui vont présenter un indice de l'ordre de 2,4 à 2,7, et/ou des cristaux, comme par exemple des cristaux de zircon ou de baddeleyite.

Il est possible de prévoir qu'une face du substrat ou que chaque face du substrat (ladite première face et/ou ladite seconde face du substrat) soit diffusante et/ou soit revêtue d'un revêtement diffusant.

Ainsi, l'interface entre ladite couche de matériau vitreux et le substrat présente une morphologie avec des échelles caractéristiques telles que la lumière est défléchie (échelles caractéristiques supérieure à 3 fois les longueurs d'onde du visible, de façon à ce que les lois de l'optique géométrique s'appliquent), ou diffusée (échelles caractéristiques comparables aux longueurs d'onde du visible, de façon à ce que l'optique ondulatoire s'applique). La lumière visible qui est émise par le matériau organique et se propage à travers le matériau vitreux haut indice est ainsi plus efficacement transférée dans le substrat d'indice plus faible.

Le substrat peut être rugueux, de rugosité définie par un paramètre de rugosité Ra allant de 1 à 5 µm, de préférence allant de 1 à 3 µm, sur une longueur d'analyse de 15 mm, et avec un filtre gaussien de fréquence de coupure à 0,8 mm.

La rugosité du substrat est caractérisée par le paramètre de rugosité bien connu Ra qui est l'écart moyen arithmétique du profil, traduisant l'amplitude moyenne. Pour définir le substrat rugueux, on peut utiliser en complément le paramètre de rugosité bien connu RSm qui est la valeur moyenne des largeurs des éléments du profil. Le paramètre RSm peut ainsi aller de 40 µm à 100 µm, encore plus préférentiellement de 45 à 65 µm, sur la longueur d'analyse de 15 mm, et avec un filtre gaussien de fréquence de coupure à 0,8 mm.

La rugosité est obtenue par un dépolissage d'un substrat en verre, grâce par exemple à de l'acide fluorhydrique. Un exemple de substrat rugueux est le verre dénommé DecorFlou® produit par la société Omnidecor (aspect satiné).

On peut aussi choisir d'autres verres attaqués à l'acide comme par exemple :
- le verre dénommé SatenGlass® produit par la société Sevasa,
- le verre dénommé Satinovo® Mate produit par la société La Veneciana de Saint-Gobain,
- le verre dénommé Dekormat® produit par la société Dekormat Glass.

Un profilomètre optique est utilisé pour les mesures de rugosité, selon le principe de la microscopie chromatique à champ étendu, par exemple à l'aide de la station de base MIM2 de la société STIL.

La mesure peut être répétée 30 fois avec des intervalles de profils de 1 mm.

Les excroissances du substrat rugueux sont par exemple sensiblement pyramidales, réparties de manière aléatoire, diffusant la lumière de manière isotrope.

Le substrat selon l'invention est destiné, en particulier, à comporter au-dessus du revêtement électrode un système électroluminescent organique. Ce dispositif OLED présente un indice (ou un indice moyen) élevé : il est égal ou plus élevé que l'indice du substrat lui-même.

L'invention se rapporte ainsi à des structures du type : Substrat bas indice / couche(s) en matériau vitreux d'indice(s) haut(s) / revêtement électrode.

La transmission lumineuse dans le visible de ce substrat avec cette structure peut être égale ou supérieure à 80%.

La présente invention se rapporte ainsi à un dispositif à diode électroluminescent organique émetteur de lumière polychromatique comportant un substrat selon l'invention, et le revêtement électrode constituant une des électrodes du dispositif.

La présente invention se rapporte également à l'utilisation d'un substrat selon l'invention, comme support dans un dispositif à diode électroluminescente organique comme un éclairage, le revêtement électrode constituant une des électrodes du dispositif.

La présente invention se rapporte également à un procédé de fabrication d'un substrat en verre comportant une première face et une seconde face opposée, notamment d'un substrat selon l'invention, ledit substrat comportant au-dessus de sa seconde face un revêtement électrode qui comporte au moins une couche électriquement conductrice, caractérisé en ce que au moins une couche de matériau vitreux présentant un indice compris entre 1,7 et 2,4 en incluant ces valeurs est déposée au-dessus de ladite seconde face dudit substrat avant le dépôt dudit revêtement électrode, ladite couche de matériau vitreux comprenant d'une part entre 40 % et 60 % en poids en incluant ces valeurs, voire entre 45 % et 58 % en poids, en incluant ces valeurs, d'oxyde de bismuth Bi₂O₃ et d'autre part entre 5 % et 30 % en poids, en incluant ces valeurs et de préférence entre 10 et 25 % en poids, en incluant ces valeurs, de ZnO et ladite couche de matériau vitreux étant de préférence déposée à partir d'une fritte, notamment par sérigraphie ou par pulvérisation.

Avantageusement, la proportion d'une part d'oxyde de bismuth dans la couche de matériau vitreux (et de préférence dans chaque couche de matériau vitreux) et d'autre part d'oxyde de zinc permet de réaliser une (ou plusieurs) couche(s) à indice(s) haut(s) et à résistance chimique renforcée. Cette résistance est obtenue par l'action combinée de ces deux oxydes au moins dans leurs plages spécifiques.

En particulier, cette résistance chimique permet d'utiliser le substrat revêtu de la couche de matériau vitreux dans des procédés de fabrication de composants et dispositifs électroniques.

En effet, le secteur de l'électronique utilise en salle propre des substrats qui doivent supporter en premier lieu des procédures de nettoyage manuel ou automatisé en bains. Ces procédures de nettoyage doivent débarrasser les supports de toute trace de matière organique ou minérale ainsi que toute trace de particules avant le dépôt du système électroluminescent organique. Chaque substrat passe donc successivement au contact de solutions détergentes basiques et acides avec des rinçages intermédiaires entre chaque étape. Le pouvoir nettoyant est en outre souvent accentué par la présence de détergents et/ou d'ultra-sons et/ou par l'utilisation d'une température proche d'environ 40 °C.

Un exemple de chaîne de bains sera ainsi constituée de :
- un premier bain d'une solution d'eau désionisée avec détergent alcalin destinée à dissoudre les matières organiques déposées ou condensées en surface, puis
- un second bain de rinçage à l'eau dure destinée à rincer et éliminer d'éventuelles traces de détergent alcalin, puis
- un troisième bain d'une solution d'eau désionisée avec détergent acide destinée à dissoudre d'éventuels polluants comme des sels de matières minérales ou des oxydes métalliques, puis
- un quatrième bain d'eau dure destiné à rincer et éliminer d'éventuelles traces de détergent acide, puis
- un cinquième et sixième bain d'eau déminéralisée pour éliminer d'éventuels sels minéraux provenant du quatrième bain d'eau dure et bien connus comme responsables de traces en particuliers sur des substrats verriers.

Chaque bain est régulé à une température d'au moins 30 à 40°C et les bains de détergence dénommés précédemment un et deux, peuvent être équipés de source ultrasonique qui facilite le renouvèlement de la solution active et accroit l'efficacité du nettoyage. Le cinquième bain peut posséder une source ultrasonique de fréquence plus élevée dans l'objectif d'éliminer des particules solides ou des fibres.

Cet exemple de chaîne destinée au nettoyage de substrats avant dépôt d'une (ou des) couche(s) de matériaux vitreux selon l'invention et peut être utilisé pour le nettoyage de ladite (ou desdits) couche(s) de matériaux vitreux avant tout dépôt d'une couche ou empilement supplémentaire.

Avantageusement encore, la solution selon l'invention peut permettre d'utiliser une couche d'indice haut au-dessus d'un substrat de verre standard, d'indice standard bas, qui permet à elle-seule d'avoir un comportement optique similaire à un ensemble substrat haut-indice + éléments diffusants. Ainsi, les deux éléments fondamentaux pour l'augmentation de l'extraction (indice et diffusion) sont réunis dans la (ou l'ensemble de) couche de matériau vitreux qui proposé(e).

La présente invention sera mieux comprise à la lecture de la description détaillée ci-après d'exemples de réalisation non limitatifs et des figures ci-jointes :
- La figure 1 illustre une vue coupe d'un substrat revêtu selon une première variante de réalisation de l'invention ; et
- La figure 2 illustre une vue coupe d'un substrat revêtu selon une seconde variante de réalisation de l'invention.

Il est précisé que dans ces figures les proportions entre les divers éléments représentés ne sont pas respectées, afin d'en faciliter la lecture.

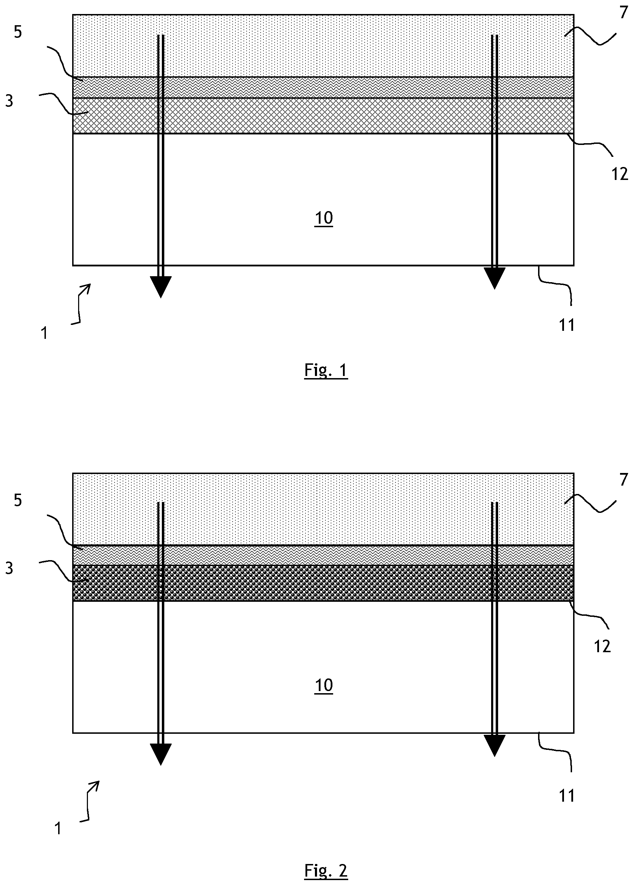

Le substrat 10 selon l'invention, tel qu'illustré en figures 1 et 2 est en verre et comporte une première face 11 et une seconde face 12 opposée à la première, ainsi qu'un chant périphérique.

Ce substrat présente un indice normal dans le sens où aucune mesure particulière n'a été prise pour qu'il présente un indice élevé et qui est compris entre 1,4 et 1,6. Dans la gamme considérée ici, cet indice est dit « bas ».

Le substrat 10 comporte au-dessus de sa seconde face 12 un revêtement électrode 5 qui est transparent et qui comporte au moins une couche électriquement conductrice, telle qu'une couche d'oxyde conductrice transparent, TCO (« Transparent Coating Oxyde ») ou une ou plusieurs couches métalliques minces, comme l'enseigne par exemple la demande internationale de brevet N° WO 2008/029060.

Selon l'invention, le substrat 10 comporte entre sa seconde face 12 et le revêtement électrode 5 au moins une couche de matériau vitreux 3 présentant un indice compris entre 1,7 et 2,4 en incluant ces valeurs et plus précisément ici entre 1,8 et 2,0 en incluant ces valeurs. Dans la gamme considérée ici, cet indice est alors dit « haut ».

Le matériau vitreux peut éventuellement présenter plusieurs couches, de composition différente, comme expliqué ci-après.

L'épaisseur totale de matériau vitreux est comprise, de préférence, entre 1 µm et 100 µm, voire entre 2 µm et 80 µm, voire entre 5 µm et 60 µm ou encore entre 5 µm et 80 µm.

Le matériau vitreux utilisé pour la couche de matériau vitreux comprend, au final lorsque déposé sur le substrat :
- d'une part entre 40 % et 60 % en poids en incluant ces valeurs d'oxyde de bismuth Bi₂O₃ et d'autre part entre 5 % et 30 % en poids, en incluant ces valeurs voire entre 10 et 25 % en poids, en incluant ces valeurs, d'oxyde de zinc ZnO ; ou,
- d'une part entre 45 % et 58 % en poids en incluant ces valeurs, d'oxyde de bismuth Bi₂O₃ et d'autre part entre 5 % et 30 % en poids, en incluant ces valeurs, voire entre 10 et 25 % en poids, en incluant ces valeurs, d'oxyde de zinc ZnO.

Sur les figures 1 et 2, au-dessus du revêtement électrode 5, un système électroluminescent organique 7 a été illustré. Les doubles flèches illustrent l'émission de la lumière par ce système.

Dans une première variante, illustrée en figure 1, ladite couche de matériau vitreux 3 est entièrement constituée d'une couche unique selon l'invention, d'indice haut.

Dans une seconde variante, illustrée en figure 2, en alternative à la première variante, la couche de matériau vitreux 3 est constituée d'une couche unique selon l'invention, d'indice haut et comporte en outre des éléments diffusants. Ces éléments diffusant permettent de donner à la couche de matériau vitreux une capacité à diffuser la lumière. Ces éléments diffusants ont une dimension caractéristique comparable ou supérieure à la longueur d'onde de la lumière dans le milieu haut indice, ce qui correspond à des dimensions comprises entre quelques centaines de nanomètres et quelques microns.

Ces éléments diffusants sont, par exemple :
- des bulles d'air dont la taille et la concentration dans la couche sont maîtrisées, et/ou
- des particules de matière d'indice différent, comme par exemple des particules à base d'oxyde de titane qui vont présenter un indice de l'ordre de 2,4 à 2,7 et/ou
- des cristaux comme par exemple des cristaux de zircon ou de baddeleyite.

Comme indiqué précédemment, il est tout à fait possible de disposer, entre la seconde face 12 et le revêtement électrode 5 plusieurs couches de matériau vitreux 3 présentant chacune un indice différent, une couche de matériau vitreux disposée en direction de ladite seconde face 12 du substrat 10 présentant un indice moins élevé qu'une autre couche de matériau vitreux disposée en direction dudit revêtement électrode 5.

Ainsi, il est possible de réaliser un gradient d'indice avec plusieurs couches de matériau vitreux 3 dont chacune est de composition différente puisque présentant un indice différent. Chaque couche de matériau vitreux 3 présente alors, de préférence un indice compris entre 1,7 et 2,4.

Il est ainsi possible de réaliser un revêtement vitreux à 2, 3, 4 ou plus encore, couches de matériau vitreux 3. Chaque couche de matériau vitreux 3 comprend alors, pour la rendre chimiquement résistante :
- d'une part entre 40 % et 60 % en poids en incluant ces valeurs d'oxyde de bismuth Bi₂O₃ et d'autre part entre 5 % et 30 % en poids, en incluant ces valeurs voire entre 10 et 25 % en poids, en incluant ces valeurs, d'oxyde de zinc ZnO ; ou,
- d'une part entre 45 % et 58 % en poids en incluant ces valeurs, d'oxyde de bismuth Bi₂O₃ et d'autre part entre 5 % et 30 % en poids, en incluant ces valeurs, voire entre 10 et 25 % en poids, en incluant ces valeurs, d'oxyde de zinc ZnO.

La composition de la (ou chaque) couche de matériau vitreux 3 selon l'invention est, de préférence, en poids :

**Tableau 1**

| | Plage large | Plage préférée |
|---|---|---|
| SiO₂ | 0-10 | 0-5 |
| Al₂O₃ | 0-5 | 0-1 |
| B₂O₃ | 8-25 | 10-22 |
| CaO | 0-10 | 0-5 |
| BaO | 0-20 | 0-15 |
| Li₂O | 0-5 | 0-3 |
| Na₂O | 0-10 | 0-5 |
| K₂O | 0-5 | 0-3 |
| Bi₂O₃ | 40-60 | 45-58 |
| ZrO₂ | 0-5 | 0-4 |
| SrO | 0-5 | 0-5 |
| La₂O₃ | 0-5 | 0-5 |
| Indice n₍₅₉₀ₙₘ₎ | 1,7 - 2,4 | 1,8 - 2,0 |

Les deux compositions suivantes (en % en poids) ont été testées pour une couche unique de matériau vitreux 3 déposée sur substrat :

**Tableau 2**

| | Ex 1 | Ex. 2 |
|---|---|---|
| SiO₂ | 12,1 | 3,8 |
| Al₂O₃ | 0,2 | 0,40 |
| B₂O₃ | 27,75 | 15,60 |
| CaO | 0 | 0 |
| BaO | 0 | 0 |
| Li₂O | 0 | 0 |
| Na₂O | 16,7 | 2,50 |
| K₂O | 0 | 0,80 |
| ZnO | 41,5 | 17,40 |
| Bi₂O₃ | 0 | 54,60 |
| ZrO₂ | 0,1 | 4,40 |
| F | 1,6 | 0 |
| SrO | 0 | 0 |
| La₂O₃ | 0 | 0 |
| Indice n₍₅₉₀ₙₘ₎ | 1,58 | 1,90 |

| | | |
|---|---|---|
| (aux erreurs de mesure près, la somme de la part de chaque constituant est égal à 100) | | |

Chacun de ces deux exemples a subi tout un ensemble de test aux acides, aux bases, aux détergents commerciaux et aux solvants récapitulés dans le tableau suivant :

**Tableau 3**

| SYSTÈME | Temperature (°C) | Temps (mn) | Aspect | Ex. 1 TL | TD | Aspect | Ex. 2 TL | TD |
|---|---|---|---|---|---|---|---|---|
| REFERENCE | | | | 77,0 | 70,0 | | 59,3 | 59,3 |
| ACIDES | | | | | | | | |
| HCl pH 2 | 25 | 10 | N3 | 62,5 | 62,2 | N1 | 59,3 | 59,3 |
| | 40 | 10 | N3 | 63,3 | 62,7 | N2 | 57,4 | 57,3 |
| HCl pH 4 | 25 | 10 | N1 | 77,5 | 70,7 | N1 | 59,4 | 59,3 |
| | 40 | 10 | N1 | 77,1 | 70,4 | N1 | 59,6 | 59,6 |
| H₂SO₄ pH 2 | 25 | 10 | N3 | 61,2 | 61,7 | N2 | 56,7 | 56,6 |
| | 40 | 10 | N3 | 64,8 | 64,0 | N2 | 59,9 | 59,7 |
| H₂SO₄ pH 4 | 25 | 10 | N1 | 77,0 | 70,4 | N1 | 59,3 | 59,3 |
| | 40 | 10 | N2 | 77,0 | 70,6 | N1 | 59,5 | 59,3 |
| | | | | | | | | |
| H₃PO₄ pH 2 | 25 | 10 | N2 | 66,5 | 65,5 | N2 | 59,2 | 59,1 |
| | 40 | 10 | N3 | 61,3 | 61,3 | N1 | 59,6 | 59,4 |
| H₃PO₄ pH 4 | 25 | 10 | N1 | 77,2 | 70,4 | N1 | 59,5 | 59,4 |
| | 40 | 10 | N2 | 77,0 | 71,0 | N1 | 59,6 | 59,3 |
| Merck Isishape 4S | 40 | 10 | N4 | X | X | N2 | 58,3 | 58,3 |
| | | | | | | | | |
| BASES | | | | | | | | |
| NaOH pH 11 | 25 | 10 | N1 | 76,7 | 71,0 | N1 | 60,0 | 60,0 |
| | 40 | 10 | N1 | 77,0 | 71,0 | N1 | 60,0 | 60,0 |
| NaOH pH 13 | 25 | 10 | N1 | 77,0 | 71,0 | N1 | 60,3 | 60,2 |
| | 40 | 10 | N1 | 77,0 | 71,0 | N1 | 60,0 | 60,0 |
| DETERGENTS COMMERCIAUX | | | | | | | | |
| Franklab Neutrax | 25 | 10 | N3 | 59,4 | 59,0 | N1 | 60,0 | 59,8 |
| 1 % pH∼4 | 40 | 10 | N3 | 54,9 | 54,5 | N2 | 60,6 | 60,4 |
| Franklab TFD 66 | 25 | 10 | N3 | 75,9 | 71,9 | N1 | 60,1 | 60,0 |
| 4 % pH∼11 | 40 | 10 | N3 | 71,4 | 70,2 | N2 | 60,4 | 60,2 |
| RBS 2 % | 25 | 10 | N2 | 76,3 | 70,3 | N1 | 59,2 | 59,0 |
| | 40 | 10 | N2 | 76,1 | 70,3 | N1 | 59,7 | 59,6 |
| SOLVANTS | | | | | | | | |
| Ethanol 95 % | 25 | 10 | N1 | 76,8 | 70,0 | N1 | 59,9 | 59,8 |
| Acetone | 25 | 10 | N1 | 77,0 | 70,0 | N1 | 59,5 | 59,4 |
| Isopropanol | 25 | 10 | N1 | 76,9 | 70,0 | N1 | 59,5 | 59,3 |

| | | | | | | | | |
|---|---|---|---|---|---|---|---|---|
| (RBS 2 % est une solution alcaline basique qui est un mélange de détergents ioniques et non ioniques + phosphates et polyphosphates à concentration en volume de 2%, soit présentant un ph de l'ordre de 11) | | | | | | | | |

Les substrats utilisés pour les tests (ex. 1 et 2) ne présentaient pas de rugosité adaptée pour l'extraction de lumière ; la face des substrats sur laquelle a été déposée la couche de matériau vitreux ne comportait pas de moyens diffusants.

Chaque test est réalisé en immergeant dans le bain spécifié dans la colonne de gauche une éprouvette de 4 cm de large et 7 cm de haut et de 2 mm d'épaisseur, chaque éprouvette étant immergée à 80 % de sa hauteur dans le bain, l'éprouvette étant constituée uniquement du substrat 10 revêtu de la couche 3 d'environ 15 µm.

La résistance chimique des deux exemples est appréciée de façon visuelle selon l'échelle de résistance suivante :
- Niveau N5 : perte totale de la couche
- Niveau N4 : dégradation forte avec disparition locale par dissolution
- Niveau N3 : dégradation significative avec changement de couleur comme irisation, blanchiment, ou matage
- Niveau N2 : début d'attaque avec apparition du front délimitant l'immersion partielle et qui correspond à l'interface liquide-air
- Niveau N1 : pas d'attaque apparente.

Les changements d'aspect sont aussi appréciés par variation des valeurs de la transmission lumineuse (TL) et de la transmission diffuse (TD). Ces valeurs sont mesurées avec un dispositif de type Hazemeter BYK.

Comme visible dans le tableau 3, les couches de l'exemple 2 comportant du Bismuth acceptent 10 mn d'immersion à 25 °C ou 40°C dans les bains suivants :
- acide à ph 4 : acide chlorhydrique, acide sulfurique, acide phosphorique.
- détergents commerciaux : Franklab neutrax 1 % pH 4, Franklab TFD 66 4 % pH 11 et RBS 25 à 2 %

Ces couches de l'exemple 2 présentent une tenue renforcée par rapport aux couches de l'exemple 1 lors de l'immersion 10 mn dans les bains suivants :
- acide à ph 2 et 25 °C : acide chlorhydrique, acide phosphorique.
- détergents commerciaux à 25 et 40 °C: Franklab neutrax 1% pH 4, Franklab TFD 66 4% pH 11 et RBS à 2%.

Ces résultats de bonne tenue chimique ont été corroborés avec des tests à la soude aux pH 11 et pH 13 ainsi que avec des tests aux ultra-sons.

Les deux compositions suivantes (en % en poids) ont été testées pour une couche unique de matériau vitreux 3 et ces deux compositions ont donnés des résultats similaires à ceux de l'exemple 2 :

**Tableau 4**

| | Ex 3 | Ex. 4 |
|---|---|---|
| SiO₂ | 3,9 | 4,14 |
| Al₂O₃ | 0,4 | 0,6 |
| B₂O₃ | 16,4 | 10 |
| CaO | 0 | 0,04 |
| BaO | 0 | 0 |
| Li₂O | 0 | < 0,05 |
| Na₂O | 2,6 | 2,15 |
| K₂O | 0,8 | 0,03 |
| ZnO | 18,3 | 25,4 |
| Bi₂O₃ | 57,5 | 57,6 |
| ZrO₂ | 0 | 0 |
| SrO | 0 | 0 |
| La₂O₃ | 0 | 0 |
| Indice n₍₅₉₀ₙₘ₎ | 1,83 | 1,91 |

| | | |
|---|---|---|
| (aux erreurs de mesure près, la somme de la part de chaque constituant est égal à 100) | | |

Il est possible par ailleurs de prévoir qu'une face du substrat ou que chaque face du substrat (ladite première face et/ou ladite seconde face du substrat) soit diffusante et/ou soit revêtue d'au moins un revêtement diffusant.

La couche de matériau vitreux 3 peut être déposée à partir d'une fritte, notamment par sérigraphie comme expliqué ci-après.

La fabrication de la couche de matériau vitreux 3 à résistance chimique renforcée peut s'effectuer selon différents procédés industriels et de préférence par sérigraphie.

### La pâte

La pâte de sérigraphie sera constituée dans des proportions massiques de 10 à 50% d'un médium de sérigraphie qui servira de véhicule aux particules pour traverser l'écran d'application. Ce médium peut être organique, constitué d'alcools, de glycols, d'esters, de terpinéol qui associé à de fines particules minérales ou des éthers cellulosiques, confère des propriétés de fluide à seuil à la pâte. Ce médium peut être aussi minéral comme des silicates de sodium, potassium ou de lithium ou encore des silices colloïdales. La fraction solide est composée essentiellement d'oxydes de métaux ou minéraux comme une fritte de verre avec une forte proportion d'oxyde de Bismuth. L'oxyde de Bismuth confère à la fois la résistance chimique de la couche et son caractère haut indice. L'indice peut encore être renforcé par l'association en moindre quantité de particules submicroniques de type oxydes, sulfates et carbonates des éléments comme le titane, baryum, zinc, calcium ....

L'empâtage des constituants s'effectue à grande vitesse dans des mixers planétaires, disperseurs à disques. Des systèmes à petite vitesse peuvent aussi être utilisés en complément que ce soit avant ou après l'opération à grande vitesse. Ces systèmes à petite vitesse sont constitués d'agitateur de type pétrin, batteur ou encore des flacons comportant des billes qui sont disposés plusieurs heures sur des agitateurs à rouleaux mus à des faibles vitesses de quelques tours par minutes. La qualité de la pâte est appréciée par l'absence de grains ou d'agrégat à l'aide d'une jauge Egman.

### Le dépôt

Les machines de dépôt peuvent être de format réduit de type électronique (EKRA, DEK) ou de taille industrielle (THIEME) comme pour le verre plat. Les écrans seront constitués de maille textile (exemple : polyester) ou métallique. Les masques peuvent être constitués de résine photosensible ou de feuilles métalliques. Les outils de nappage et la racle seront en polymère, carbone ou métal. Les épaisseurs déposées sont de 10 à 100 µm sur substrat verrier. La maitrise de l'épaisseur est d'abord assurée par le choix de la maille de l'écran et sa tension. La maitrise de l'épaisseur est aussi assurée par les réglages de la distance entre l'écran et le substrat ainsi que les pressions et les vitesses de déplacement appliquées à la racle. Les épaisseurs seront contrôlées à l'aide d'un banc optique à laser de type Rodenstock entre une zone revêtue ou non. Les dépôts sont séchés à une température de l'ordre de 100 à 150 °C dans un tunnel à rayonnement infrarouge ou UV selon la nature du médium employé.

Le dépôt de la couche haut indice peut aussi être effectué par un autre moyen que la sérigraphie : par exemple par dépôt par rouleau (« roll coating »), dépôt par trempage (« dip coating »), dépôt par application au couteau (« knifecoating »), dépôt par pulvérisation, par tournette (« spin coating ») ou encore dépôt par nappage vertical (« flow coating »).

Les changements des ratios poudre-liquides et l'emploi d'additif est utilisé pour adapter la rhéologie de la composition au mode de dépôt choisi. Deux modes de dépôt différents peuvent être employés successivement pour réaliser un empilement de couches semblables ou de compositions différentes ou à gradient d'un ou plusieurs constituants.

### La cuisson

Les fours employés peuvent être dynamiques avec transport sur rouleaux comme pour la cuisson de lunette arrière automobile ou préférentiellement statiques avec positionnement sur plaques métalliques ou vitrocéramique pour conservation de la planéité du substrat. Un mode privilégié sera une cuisson avec montée lente 5 à 10 °C/mn comportant des paliers de quelques minutes à plusieurs dizaines de minutes. Le temps de maintien et la température de cuisson située entre 550 et 670 °C permet de minimiser la rugosité, maitriser le nombre et la taille de bulles, limiter la croissance de cristaux.

### La résistance au nettoyage

Le secteur de l'électronique utilise couramment en salle propre des substrats comportant ou non des couches qui doivent supporter en premier lieu des procédures de nettoyages manuels ou automatisés en bains. Ces procédures de nettoyage doivent débarrasser les supports de toute trace de matière organique ou minérale ainsi que de particules. Les substrats passent donc successivement des étapes au contact de solutions détergentes basiques et acides avec des rinçages intermédiaires. Le pouvoir nettoyant est accentué par la présence de détergents, d'ultra-sons et une température souvent proche de 40 °C.

La composition riche en bismuth et contenant du zinc de la couche vitreuse haut indice lui confère une résistance élevée dans ces milieux agressifs tels que les bains précités. Une couche vitreuse de type zinc borate (comme celle de l'exemple 1) élaborée selon le même processus d'élaboration se voit complètement détruite dans les mêmes conditions de nettoyage. L'évaluation de la dégradation de ces couches à caractère diffusant s'effectue par mesure de la modification des valeurs de transmission lumineuses et diffuses à l'aide d'un Hazemeter (Hazeguard BYK).

Deux types d'électrodes ont été déposées sur deux échantillons de l'exemple 2 :
- d'une part une électrode en TCO à base d'ITO déposé à chaud (300°C) avec une montée en température rapide du substrat (de l'ordre de 50 °C par minutes)
- et d'autre part une électrode en TCC par pulvérisation cathodique à froid en suivant l'enseignement de la demande internationale de brevet N° WO 2008/029060,
et en faisant subir pour chacun des échantillons le nettoyage nécessaire précité avant le dépôt de chaque électrode.

Aucune dégradation de la couche en matériau vitreux n'a été observée, ni avant, ni après le dépôt des électrodes.

La résistance chimique de la couche de matériau vitreux selon l'invention est accentuée par le fait que la couche de matériau vitreux présente une composition en oxydes hydrosolubles qui est faible. Les oxydes hydrosolubles sont notamment les oxydes alcalins de type sodium et potassium dont la teneur sera inférieure à 15 % en poids et préférentiellement inférieure à 5 %.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (10) en verre comportant une première face (11) et une seconde face (12) opposée à la première face, ledit substrat (10) comportant au-dessus de sa seconde face un revêtement électrode (5) qui comporte au moins une couche électriquement conductrice avec au moins une couche de matériau vitreux (3) comporte des éléments diffusants qui sont des particules de matière d'indice différent de celui de la couche de matériau vitreux et/ou ledit substrat (10) comporte des éléments diffusants et/ou en ce que ladite première face (11) du substrat (10) est diffusante et/ou est revêtue d'un revêtement diffusant,
**caractérisé en ce que** ledit substrat (10) comporte entre sa seconde face (12) et le revêtement électrode (5) au moins une couche de matériau vitreux (3) présentant un indice compris entre 1,7 et 2,4 en incluant ces valeurs et comprenant d'une part entre 40 % et 60 % en poids en incluant ces valeurs, voire entre 45 % et 58 % en poids, en incluant ces valeurs, d'oxyde de bismuth Bi₂O₃ et d'autre part entre 5 % et 30 % en poids, en incluant ces valeurs et de préférence entre 10 et 25 % en poids, en incluant ces valeurs, de ZnO.

2. Substrat (10) selon la revendication 1, **caractérisé en ce que** ladite couche de matériau vitreux (3) présente une épaisseur comprise, entre 1 µm et 100 µm, voire entre 2 µm et 80 µm, voire entre 5 µm et 60 µm.

3. Substrat (10) selon la revendication 1 ou la revendication 2, **caractérisé en ce que** ledit substrat (10) comporte entre sa seconde face (12) et le revêtement électrode (5) plusieurs couches de matériau vitreux (3) présentant chacune un indice différent, une couche de matériau vitreux disposée en direction de ladite seconde face (12) du substrat (1) présentant un indice inférieur à celui d'une autre couche de matériau vitreux disposée en direction dudit revêtement électrode (5) et lesdites couches de matériau vitreux (3) comprenant, de préférence toutes, d'une part entre 40 % et 60 % en poids en incluant ces valeurs , voire entre 45 % et 58 % en poids en incluant ces valeurs, d'oxyde de bismuth Bi₂O₃ et d'autre part entre 5 % et 30 % en poids, en incluant ces valeurs et de préférence entre 10 et 25 % en poids, en incluant ces valeurs, de ZnO.

4. Substrat (10) selon l'une quelconque des revendications 1 à 3, **caractérisé en ce qu'**au moins une couche de matériau vitreux (3) comporte, en poids :
- entre 0 % et 10 % et de préférence entre 0 et 5 % de SiO₂,
- entre 0 % et 5 % et de préférence entre 0 et 1 % d'Al₂O₃,
- entre 8 % et 25 % et de préférence entre 10 et 22 % de B₂O₃,
- entre 0 % et 10 % et de préférence entre 0 et 5 % de CaO,
- entre 0 % et 20 % et de préférence entre 0 et 15 % de BaO,
- entre 0 % et 5 % et de préférence entre 0 et 3 % de Li₂O,
- entre 0 % et 10 % et de préférence entre 0 et 5 % de Na₂O,
- entre 0 % et 5 % et de préférence entre 0 et 3 % de K₂O,
- entre 0 % et 5 % et de préférence entre 0 et 4 % de ZrO₂,
- entre 0 % et 5 % de SrO,
- entre 0 % et 5 % deLa₂O₃,
en incluant ces valeurs dans les plages.

5. Substrat (10) selon l'une quelconque des revendications 1 à 4, **caractérisé en ce que** les éléments diffusants sont des bulles d'air et les particules de matière d'indice différent de celui de la couche de matériau vitreux.

6. Substrat (10) selon l'une quelconque des revendications 1 à 5, **caractérisé en ce que** ladite première face (11) du substrat (10) est diffusante ou est revêtue d'un revêtement diffusant.

7. Substrat (10) selon l'une quelconque des revendications 1 à 6, **caractérisé en ce que** ladite seconde face (12) du substrat (10) est diffusante et/ou est revêtue d'un revêtement diffusant.

8. Substrat (10) selon l'une quelconque des revendications 1 à 7, **caractérisé en ce qu'il** comporte au-dessus du revêtement électrode (5) un système électroluminescent organique (7).

9. Dispositif à diode électroluminescent organique émetteur de lumière polychromatique comportant un substrat (10) selon l'une quelconque des revendications 1 à 8, et le revêtement électrode (5) constituant une des électrodes du dispositif.

10. Utilisation d'un substrat (10) selon l'une quelconque des revendications 1 à 8, comme support dans un dispositif à diode électroluminescente organique comme un éclairage, le revêtement électrode (5) constituant une des électrodes du dispositif.

## Patentansprüche

1. Substrat (10) aus Glas, das eine erste Seite (11) und eine zweite Seite (12) aufweist, die der ersten gegenüberliegt, wobei das Substrat (10) über seiner zweiten Seite eine Elektrodenbeschichtung (5) aufweist, die mindestens eine elektrisch leitende Schicht aufweist, mit mindestens einer Schicht aus glasartigem Material (3), weist Streuelemente auf, bei denen es sich um Teilchen aus einem Stoff mit einem anderen Brechungsindex als dem Brechungsindex der Schicht aus glasartigem Material handelt, und/oder das Substrat (10) Streuelemente aufweist und/oder dadurch, dass die erste Seite (11) des Substrats (10) streut und/oder mit einer streuenden Beschichtung überzogen ist, **dadurch gekennzeichnet, dass** das Substrat (10) zwischen seiner zweiten Seite (12) und der Elektrodenbeschichtung (5) mindestens eine Schicht aus glasartigem Material (3) mit einem Brechungsindex zwischen 1,7 und 2,4, einschließlich dieser Werte, aufweist, die einerseits zwischen 40 Gewichts-% und 60 Gewichts-%, einschließlich dieser Werte, sowie zwischen 45 Gewichts-% und 58 Gewichts-%, einschließlich dieser Werte, Bismutoxid Bi₂O₃ und andererseits zwischen 5 Gewichts-% und 30 Gewichts-%, einschließlich dieser Werte, und vorzugsweise zwischen 10 und 25 Gewichts-%, einschließlich dieser Werte, ZnO umfasst.

2. Substrat (10) nach Anspruch 1, **dadurch gekennzeichnet, dass** die Schicht aus glasartigem Material (3) eine Dicke zwischen 1 µm und 100 µm sowie zwischen 2 µm und 80 µm sowie zwischen 5 µm und 60 µm aufweist.

3. Substrat (10) nach Anspruch 1 oder Anspruch 2, **dadurch gekennzeichnet, dass** das Substrat (10) zwischen seiner zweiten Seite (12) und der Elektrodenbeschichtung (5) mehrere Schichten aus glasartigem Material (3) aufweist, die jeweils einen anderen Brechungsindex aufweisen, wobei eine in Richtung der zweiten Seite (12) des Substrats (1) angeordnete Schicht aus glasartigem Material einen niedrigeren Brechungsindex als der einer weiteren Schicht aus glasartigem Material aufweist, die in Richtung der Elektrodenbeschichtung (5) angeordnet ist, und wobei die, vorzugsweise alle, Schichten aus glasartigem Material (3) einerseits zwischen 40 Gewichts-% und 60 Gewichts-%, einschließlich dieser Werte, sowie zwischen 45 Gewichts-% und 58 Gewichts-%, einschließlich dieser Werte, Bismutoxid Bi₂O₃ und andererseits zwischen 5 Gewichts-% und 30 Gewichts-%, einschließlich dieser Werte, und vorzugsweise zwischen 10 und 25 Gewichts-%, einschließlich dieser Werte, ZnO umfassen.

4. Substrat (10) nach einem der Ansprüche 1 bis 3, **dadurch gekennzeichnet, dass** mindestens eine Schicht aus glasartigem Material (3) in Gewichtsprozent umfasst:
- zwischen 0 % und 10 % und vorzugsweise zwischen 0 und 5 % SiO₂,
- zwischen 0 % und 5 % und vorzugsweise zwischen 0 und 1 % Al₂O₃,
- zwischen 8 % und 25 % und vorzugsweise zwischen 10 und 22 % B₂O₃,
- zwischen 0 % und 10 % und vorzugsweise zwischen 0 und 5 % CaO,
- zwischen 0 % und 20 % und vorzugsweise zwischen 0 und 15 % BaO,
- zwischen 0 % und 5 % und vorzugsweise zwischen 0 und 3 % Li₂O,
- zwischen 0 % und 10 % und vorzugsweise zwischen 0 und 5 % Na₂O,
- zwischen 0 % und 5 % und vorzugsweise zwischen 0 und 3 % K₂O,
- zwischen 0 % und 5 % und vorzugsweise zwischen 0 und 4 % ZrO₂,
- zwischen 0 % und 5 % SrO,
- zwischen 0 % und 5 % La₂O₃,
wobei diese Werte in den Wertebereichen eingeschlossen sind.

5. Substrat (10) nach einem der Ansprüche 1 bis 4, **dadurch gekennzeichnet, dass** die Streuelemente Luftblasen und Teilchen aus einem Stoff mit einem anderen Brechungsindex als der der Schicht aus glasartigem Material sind.

6. Substrat (10) nach einem der Ansprüche 1 bis 5, **dadurch gekennzeichnet, dass** die erste Seite (11) des Substrats (10) streut oder mit einer streuenden Beschichtung überzogen ist.

7. Substrat (10) nach einem der Ansprüche 1 bis 6, **dadurch gekennzeichnet, dass** die zweite Seite (12) des Substrats (10) streut und/oder mit einer streuenden Beschichtung überzogen ist.

8. Substrat (10) nach einem der Ansprüche 1 bis 7, **dadurch gekennzeichnet, dass** es über der Elektrodenbeschichtung (5) ein organisches elektrolumineszierendes System (7) umfasst.

9. Bauelement mit organischer Leuchtdiode, die polychromatisches Licht aussendet, das ein Substrat (10) nach einem der Ansprüche 1 bis 8 aufweist, und wobei die Elektrodenbeschichtung (5) eine der Elektroden des Bauelements bildet.

10. Verwendung eines Substrats (10) nach einem der Ansprüche 1 bis 8, als Träger in einem Bauelement mit organischer Leuchtdiode als Beleuchtung, wobei die Elektrodenbeschichtung (5) eine der Elektroden des Bauelements bildet.

## Claims

1. Glass substrate (10) comprising a first face (II) and a second face (12) opposing the first face, said substrate (10) comprising, above its second face, an electrode layer (5) which comprises at least one electrically conducting layer where at least one layer of vitreous material (3) comprises diffusing elements which are particles of material of index different from that of the layer of vitreous material and/or said substrate (10) comprises diffusing elements and/or in that said first face (11) of the substrate (10) is a diffusing surface and/or is coated with a diffusing layer, **characterized in that** said substrate (10) comprises, between its second face (12) and the electrode layer (5), at least one layer of vitreous material (3) having an index in the range between 1.7 and 2.4 including these values and comprising, on the one hand, between 40% and 60% by weight including these values, or even between 45% and 58% by weight, including these values, of bismuth oxide Bi₂O₃ and, on the other hand, between 5% and 30% by weight, including these values and preferably between 10 and 25% by weight, including these values, of ZnO.

2. Substrate (10) according to Claim 1, **characterized in that** said layer of vitreous material (3) has a thickness in the range between 1 µm and 100 µm, or between 2 µm and 80 µm, or even between 5 µm and 60 µm.

3. Substrate (10) according to either of Claims 1 and 2, **characterized in that** said substrate (10) comprises between its second face (12) and the electrode layer (5) several layers of vitreous material (3) each having a different index, a layer of vitreous material disposed in the direction of said second face (12) of the substrate (1) having an index lower than that of another layer of vitreous material disposed in the direction of said electrode layer (5) and said layers of vitreous material (3) preferably all comprising, on the one hand, between 40% and 60% by weight including these values, or even between 45% and 58% by weight including these values, of bismuth oxide Bi₂O₃ and, on the other hand, between 5% and 30% by weight, including these values, and preferably between 10 and 25% by weight, including these values, of ZnO.

4. Substrate (10) according to any one of Claims I to 3, **characterized in that** at least one layer of vitreous material (3) comprises, by weight:
- between 0% and 10% and preferably between 0 and 5% of SiO₂,
- between 0% and 5% and preferably between 0 and 1% of Al₂O₃,
- between 8% and 25% and preferably between 10 and 22% of B₂O₃,
- between 0% and 10% and preferably between 0 and 5% of CaO,
- between 0% and 20% and preferably between 0 and 15% of BaO,
- between 0% and 5% and preferably between 0 and 3% of Li₂O,
- between 0% and 10% and preferably between 0 and 5% of Na₂O,
- between 0% and 5% and preferably between 0 and 3% of K₂O,
- between 0% and 5% and preferably between 0 and 4% of ZrO₂,
- between 0% and 5% of SrO,
- between 0% and 5% of La₂O₃,
including these values in the ranges.

5. Substrate (10) according to any one of Claims 1 to 4, **characterized in that** the diffusing elements are air bubbles and the particles of material with an index different from that of the layer of vitreous material.

6. Substrate (10) according to any one of Claims I to 5, **characterized in that** said first face (11) of the substrate (10) is a diffusing surface or is coated with a diffusing layer.

7. Substrate (10) according to any one of Claims 1 to 6, **characterized in that** said second face (12) of the substrate (10) is a diffusing surface and/or is coated with a diffusing layer.

8. Substrate (10) according to any one of Claims 1 to 7, **characterized in that** it comprises, above the electrode layer (5), an organic light-emitting system (7).

9. Device with an organic light-emitting diode emitting polychromatic light comprising a substrate (10) according to any one of Claims 1 to 8, and the electrode layer (5) forming one of the electrodes of the device.

10. Use of a substrate (10) according to any one of Claims 1 to 8 as a support in a device with an organic light-emitting diode such as a lighting system, the electrode layer (5) forming one of the electrodes of the device.
